# EUROPEAN PATENT APPLICATION

(11) **EP 4 576 544 A1**
(43) Date of publication of application: **25.06.2025**
(21) Application number: 23891481.6
(22) Date of filing: 10.11.2023
(51) Int. Cl.: H02M 7/48, H02K 11/33

(54) **VEHICULAR DRIVE DEVICE**

(30) Priority: 16.11.2022 JP 2022183250
(71) Applicant: AISIN CORPORATION, Kariya-shi, Aichi 448-8650 (JP)
(72) Inventor: NITTA, Masaru, Kariya-shi, Aichi 448-8650 (JP); KOASHI, Hidefumi, Kariya-shi, Aichi 448-8650 (JP); MAENO, Yuya, Kariya-shi, Aichi 448-8650 (JP)
(74) Representative: Kramer Barske Schmidtchen Patentanwälte PartG mbB
(86) International application number: PCT/JP2023/040556
(87) International publication number: WO 2024/106333

(57) **Abstract**

There is disclosed a vehicular drive device including a power conversion device that supplies power to a rotary electric machine, a case that houses the power conversion device, a Y capacitor that is housed in the case and electrically connected between the power conversion device and a power supply, a first terminal that electrically connects the Y capacitor to a positive side of the power supply, a second terminal that electrically connects the Y capacitor to a negative side of the power supply, and a third terminal that electrically connects the Y capacitor to a ground, the first terminal and the second terminal have a first fastening surface with a terminal from a power supply side, a normal direction of the first fastening surface being a first direction, and the third terminal has a second fastening surface with a member having a ground potential, a normal direction of the second fastening surface being a second direction different from the first direction.

## Description

### TECHNICAL FIELD

The present disclosure relates to a vehicular drive device.

### BACKGROUND ART

A technique is known in which two noise removing capacitor elements (Y capacitors) are arranged in a case together with a power conversion device.

### CITATIONS LIST

### PATENT LITERATURE

Patent Literature 1: JP 2021-22655 A

### SUMMARY OF INVENTION

### TECHNICAL PROBLEMS

However, in the conventional technique described above, the fastening surfaces of a plurality of connection terminals of the Y capacitor are all directed in the vertical direction, and it is difficult to reduce the mounting space of the Y capacitor.

Therefore, in one aspect, the present disclosure reduces a mounting space of a Y capacitor.

### SOLUTIONS TO PROBLEMS

In one aspect, there is provided a vehicular drive device including
a power conversion device that supplies power to a rotary electric machine,
a case that houses the power conversion device,
a Y capacitor that is housed in the case and electrically connected between the power conversion device and a power supply,
a first terminal that electrically connects the Y capacitor to a positive side of the power supply,
a second terminal that electrically connects the Y capacitor to a negative side of the power supply, and
a third terminal that electrically connects the Y capacitor to a ground,
the first terminal and the second terminal have a first fastening surface with a terminal from a power supply side, a normal direction of the first fastening surface being a first direction, and
the third terminal has a second fastening surface with a member having a ground potential, a normal direction of the second fastening surface being a second direction different from the first direction.

### ADVANTAGEOUS EFFECTS OF INVENTION

In one aspect, according to the present disclosure, the mounting space of the Y capacitor can be reduced.

### BRIEF DESCRIPTION OF DRAWINGS

FIG. 1 is a schematic cross-sectional view of a vehicular drive device according to the present embodiment.
FIG. 2 is a diagram illustrating an example of an electric circuit including a power conversion device.
FIG. 3 is a perspective view of a mounting structure of a Y capacitor.
FIG. 4 is an exploded perspective view in which a part of FIG. 3 is exploded.
FIG. 5 is an exploded perspective view in which a part of FIG. 4 is further exploded.
FIG. 5A is an exploded perspective view illustrating three types of terminals (P terminal, N terminal, and GN terminal).
FIG. 6 is an explanatory diagram of three types of Y capacitors according to a comparative example.
FIG. 7 is a front view of the mounting structure of the Y capacitor when viewed in a Y direction.
FIG. 8 is a plan view of the mounting structure of the Y capacitor when viewed in a Z direction.

### DESCRIPTION OF EMBODIMENTS

Hereinafter, each embodiment will be described in detail with reference to the accompanying drawings. Note that the dimensional ratios in the drawings are merely examples, and the dimensional ratios are not limited thereto, and shapes and the like in the drawings may be partially exaggerated for convenience of description.

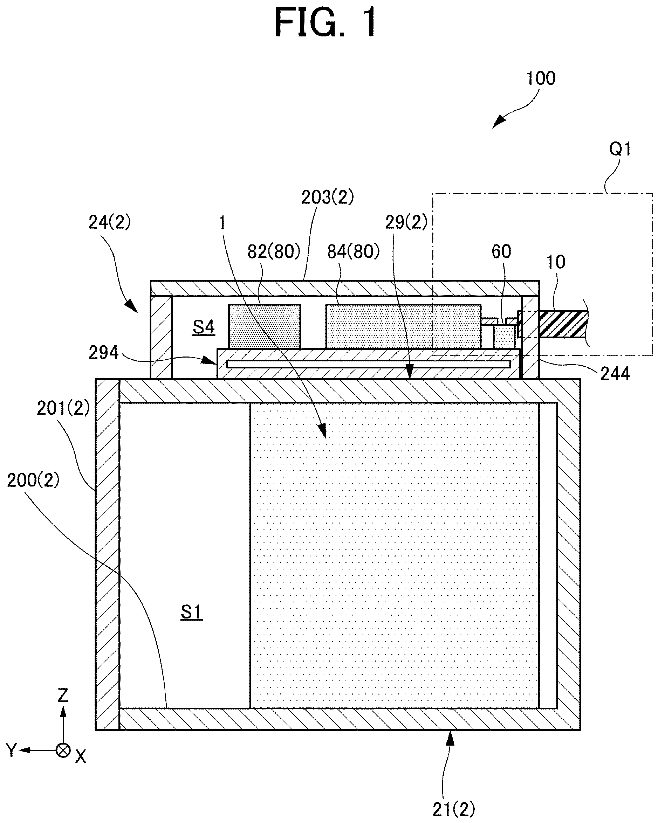

FIG. 1 is a schematic cross-sectional view of a vehicular drive device 100 according to the present embodiment. FIG. 1 and the like illustrate a coordinate system (right-handed coordinate system) representing orthogonal triaxial directions. In the following description, the Z direction corresponds to the vertical direction in the usage status of the vehicular drive device 100, that is, the vertical direction in a case where the vehicular drive device 100 is disposed in the direction in the usage status. Then, the description will be given assuming that the positive side in the Z direction corresponds to the upper side and the negative side corresponds to the lower side.

A vehicle to which the vehicular drive device 100 is applied may be any vehicle including a rotary electric machine 1 as a drive source, and may be an electric car, a hybrid car, or the like.

The vehicular drive device 100 includes a case 2 that houses various components. In the present embodiment, the case 2 houses the rotary electric machine 1, a power conversion device 80, and the like.

The case 2 may be formed by combining a plurality of case members. In the following description, as an example, it is assumed that the case 2 is formed by joining a case member 200, a cover member 201, and an inverter cover member 203. Note that the joining method may be fastening with a bolt or the like.

The case 2 includes a motor case portion 21 and an inverter case portion 24 in an integrated form. Here, the "integrated form" includes a form in which the portions are integrated with a fastening member such as a bolt and a form in which the portions are integrated by integral molding (for example, casting).

Note that, in a modification, other drive elements may be housed in the case 2. For example, a reduction mechanism, a differential gear device, or the like that can be disposed between the rotary electric machine 1 and the wheels may be housed in the case 2.

The motor case portion 21 forms a motor housing chamber S1 that houses the rotary electric machine 1. The motor case portion 21 may be in a tubular form (for example, form with a circular cross-section or a polygonal cross-section) corresponding to the outer shape of the rotary electric machine 1. The rotary electric machine 1 functions as a drive source of a vehicle. The rotary electric machine 1 is, for example, a three-phase motor, and may be of an inner rotor type.

Note that the motor case portion 21 does not need to have an entirely closed cylindrical outer circumferential portion. For example, in a configuration in which the reduction mechanism or the differential gear device (not illustrated) is disposed in the case 2, the space within the motor case portion 21 may communicate with the space in which the output shaft between the wheel and the differential gear device is disposed.

The inverter case portion 24 is disposed on the top of the motor case portion 21 or the like. The inverter case portion 24 forms an inverter housing chamber S4 that houses the power conversion device 80.

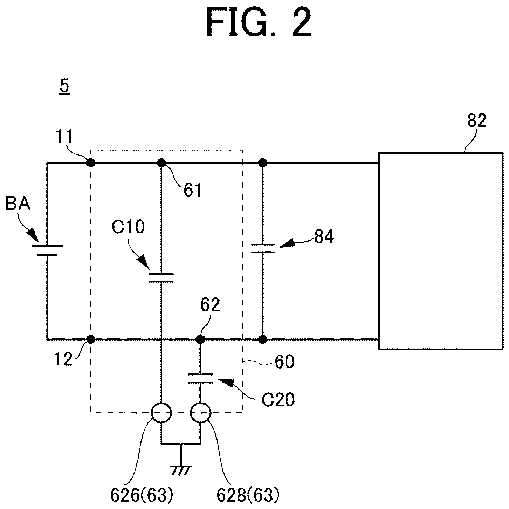

In the present embodiment, a power supply connector 10 is attached to the inverter case portion 24. The power supply connector 10 supplies power from a power supply BA to the rotary electric machine 1 via the power conversion device 80. The power supply connector 10 includes a positive terminal 11 and a negative terminal 12 to be described later with reference to FIG. 2.

The power supply connector 10 may be fitted into a hole (not illustrated) in a side wall portion 244 of the inverter case portion 24. In this case, the power supply connector 10 may be attached to the side wall portion 244 so as to be inserted in the Y direction.

The power conversion device 80 is electrically connected between the rotary electric machine 1 and the power supply BA. The power conversion device 80 may be in the form of a module in which various components are integrated. The power conversion device 80 may include a plurality of switching elements (power semiconductor elements) constituting an inverter circuit 82, a control board on which a control device for controlling the inverter circuit 82 (see FIG. 2) is mounted, a smoothing capacitor 84 (see FIG. 2), and the like.

Note that, as illustrated in FIG. 1, the power conversion device 80 may be fixed to a partition wall portion 29 forming the bottom of the inverter case portion 24. The partition wall portion 29 is a wall portion that partitions between the motor housing chamber S1 and the inverter housing chamber S4. More specifically, the power conversion device 80 may be fixed to the partition wall portion 29 via a water passage forming member 294, which is a member different from the partition wall portion 29. A water passage through which cooling water passes may be formed in the water passage forming member 294. Note that, in the modification, the water passage may be formed in the partition wall portion 29, and the power conversion device 80 may be cooled together with the rotary electric machine 1 by the partition wall portion 29. In this case, the power conversion device 80 may be directly fixed to the partition wall portion 29.

As described above, in the present embodiment, the case 2 integrally forms the motor housing chamber S1 in which the rotary electric machine 1 is disposed and the inverter housing chamber S4 (second housing chamber) in which the power conversion device 80 is disposed while partitioning these chambers by the partition wall portion 29.

The rotary electric machine 1 and the power conversion device 80 are electrically connected via a wiring structure 9. The wiring structure 9 may include a power line (not illustrated) from the rotary electric machine 1 and each bus bar (not illustrated) for every phase.

FIG. 2 is a diagram illustrating an example of an electric circuit 5 including the power conversion device 80. The electric circuit 5 is an electric circuit for driving the rotary electric machine 1.

The electric circuit 5 includes the power supply BA, a Y capacitor 60, the inverter circuit 82, and the smoothing capacitor 84. The rotary electric machine 1 (FIG. 1) is connected to the inverter circuit 82.

The smoothing capacitor 84 is connected between the positive-side line of the power supply BA and the negative-side line of the power supply BA.

The Y capacitor 60 is provided for handling noise. The Y capacitor 60 includes a Gp terminal 626 connecting the positive-side line to the ground, a Gn terminal 628 connecting the negative-side line to the ground, a capacitor C10, and a capacitor C20. The capacitor C10 is connected between the positive-side line and the Gp terminal 626. The capacitor C10 is connected to the positive-side line at a P terminal 61. The capacitor C20 is connected between the negative-side line and the Gn terminal 628. The capacitor C20 is connected to the negative-side line at an N terminal 62.

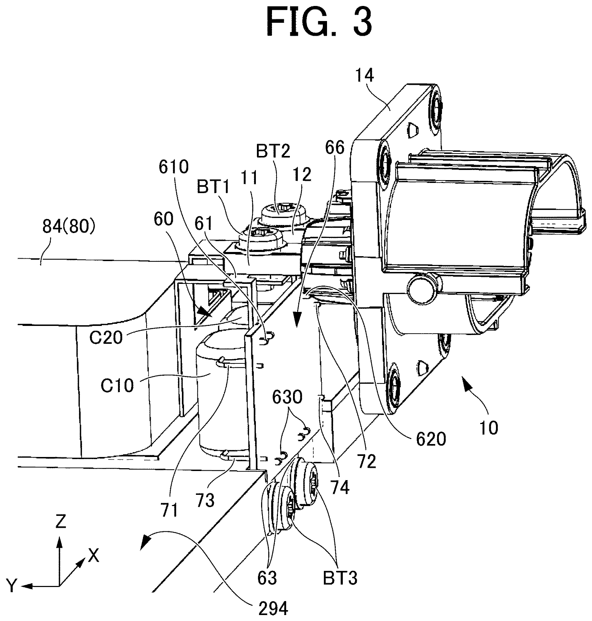

Next, the mounting structure of the Y capacitor 60 in the present embodiment will be described with reference to FIG. 3 and subsequent drawings.

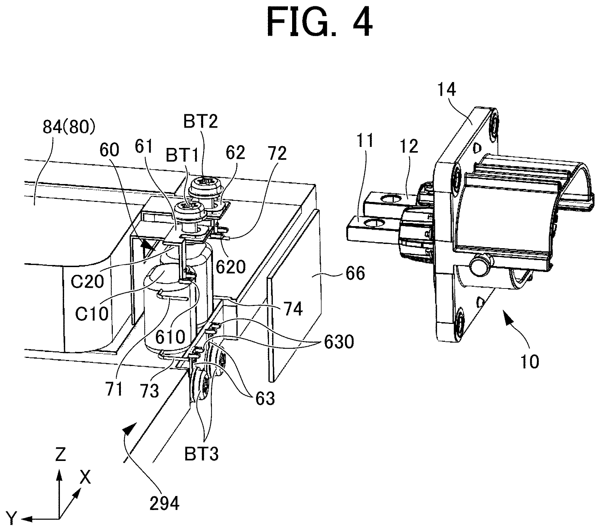

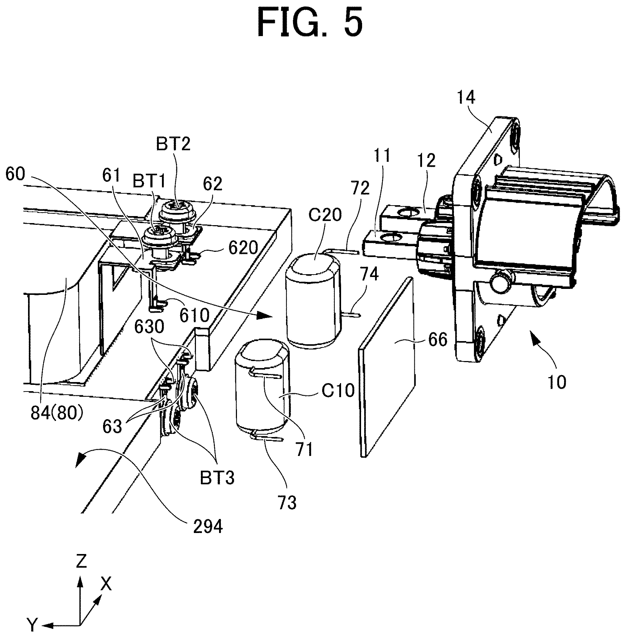

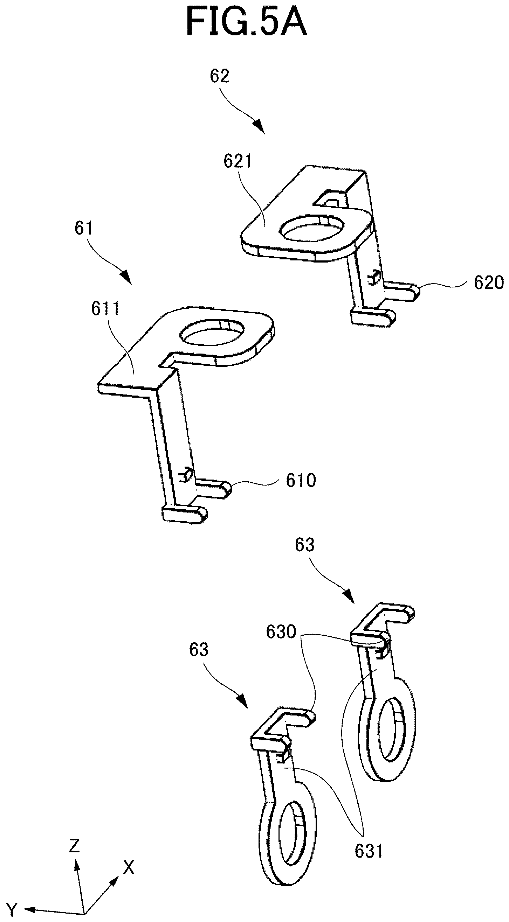

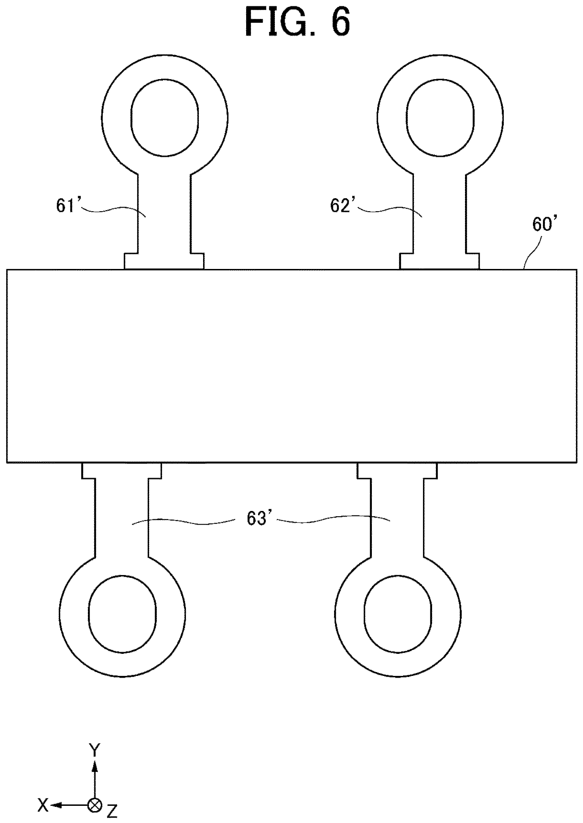

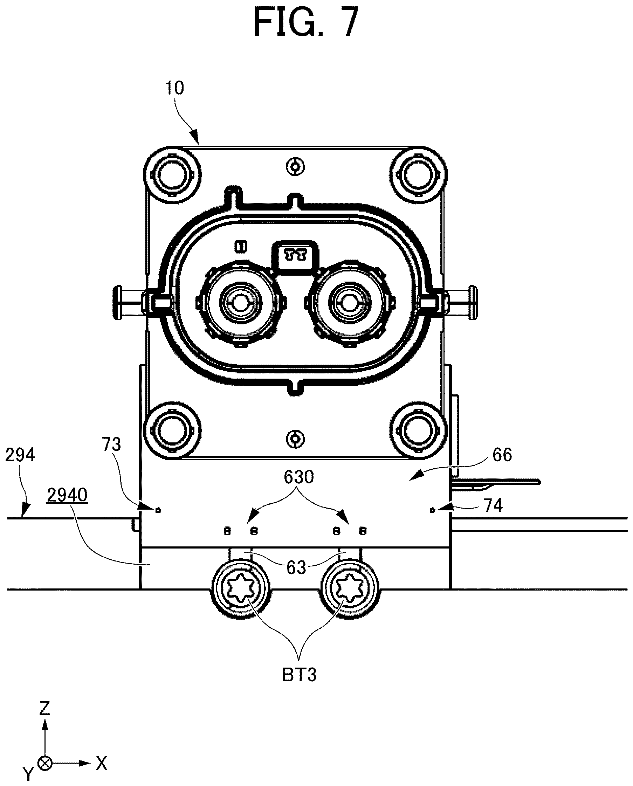

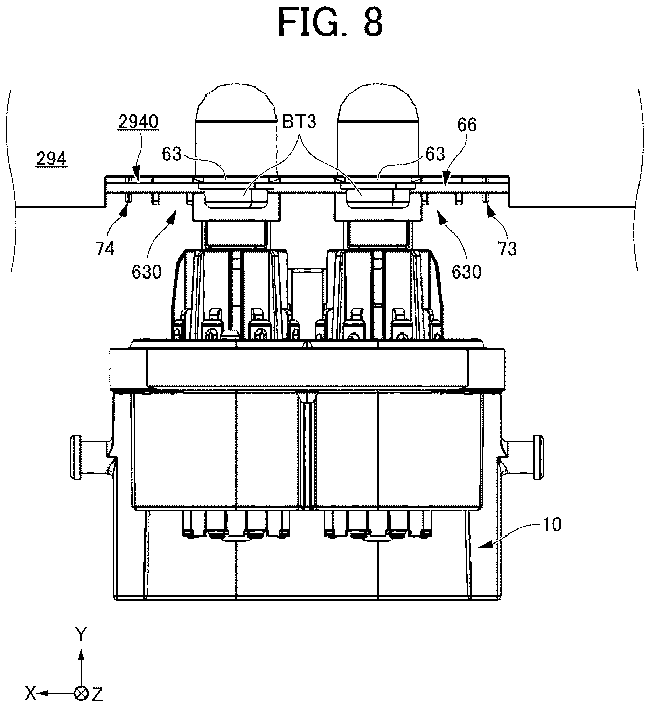

FIG. 3 is a perspective view of the mounting structure of the Y capacitor 60, and is a perspective view illustrating a structure in a portion Q1 of FIG. 1. FIG. 4 is an exploded perspective view in which a part of FIG. 3 is exploded, and FIG. 5 is an exploded perspective view in which a part of FIG. 4 is further exploded. FIG. 5A is an exploded perspective view illustrating three types of terminals (P terminal 61, N terminal 62, and ground terminal 63). FIG. 6 is an explanatory diagram of a comparative example. FIG. 7 is a front view of the mounting structure of the Y capacitor 60 when viewed in the Y direction, and FIG. 8 is a plan view of the mounting structure of the Y capacitor 60 when viewed in the Z direction.

The Y capacitor 60 is electrically connected to the power supply BA via the power supply connector 10. As described above, the power supply connector 10 includes the positive terminal 11 and the negative terminal 12. The power supply connector 10 has an attachment portion 14 extending in the XZ plane, and the attachment portion 14 is brought into contact with the side wall portion 244 (not illustrated in FIG. 3, see FIG. 1) of the inverter case portion 24 in the Y direction. At this time, the positive terminal 11 and the negative terminal 12 extend to the inside of the inverter case portion 24 (that is, inverter housing chamber S4).

The terminal configuration of the Y capacitor 60 includes the P terminal 61 and the N terminal 62 described above, and ground terminals 63 forming two terminals, that is, the Gp terminal 626 and the Gn terminal 628 described above.

The P terminal 61 electrically connects the capacitor C10 to the positive side of the power supply BA. In the present embodiment, one end 610 (see FIG. 4, FIG. 5A, and the like) of the P terminal 61 is joined to a board 66, and the other end is joined (fastened) to the positive terminal 11 of the power supply connector 10. The capacitor C10 has a positive-side terminal 71 and a ground-side terminal 73 joined to the board 66 (see FIG. 5). In this case, the positive-side terminal 71 of the capacitor C10 is electrically connected to the one end 610 of the P terminal 61 via the board 66. The board 66 extends in a plane parallel to the side wall portion 244 (that is, in the XZ plane) and overlaps the capacitor C10 and the capacitor C20 when viewed in the Y direction. That is, the board 66 is disposed between the capacitor C10 and the capacitor C20, and the side wall portion 244 (see FIG. 1) in the Y direction.

The N terminal 62 electrically connects the capacitor C20 to the negative side of the power supply BA. In the present embodiment, one end 620 (see FIG. 4, FIG. 5A, and the like) of the N terminal 62 is joined to the board 66, and the other end is joined (fastened) to the negative terminal 12 of the power supply connector 10. The capacitor C20 has a negative-side terminal 72 and a ground-side terminal 74 joined to the board 66 (see FIG. 5). In this case, the negative-side terminal 72 of the capacitor C20 is electrically connected to the one end 620 of the N terminal 62 via the board 66.

Each of the two ground terminals 63 electrically connects each of the capacitors C10 and C20 to the ground. In the present embodiment, one end 630 (see FIG. 4, FIG. 5A, and the like) of each ground terminal 63 is joined to the board 66, and the other end is joined (fastened) to a member having a ground potential (in the present embodiment, the water passage forming member 294). The ground-side terminal 73 of the capacitor C10 is electrically connected to the one end 630 of one ground terminal 63 via the board 66, and the ground-side terminal 74 of the capacitor C20 is electrically connected to the one end 630 of the other ground terminal 63 via the board 66.

In this manner, according to the present embodiment, the capacitors C10 and C20 can be electrically connected to the power supply BA and the ground using the board 66 parallel to the side wall portion 244. As a result, the mounting space (mounting space in the Y direction) of the Y capacitor 60 can be reduced as described later.

In the present embodiment, as well illustrated in FIG. 5A, the P terminal 61 has a fastening surface 611 whose normal direction is the vertical direction (example of first direction). The fastening surface 611 forms a fastening surface (a surface having a hole for fastening a bolt BT1) with the positive terminal 11 of the power supply connector 10. That is, the P terminal 61 and the positive terminal 11 overlap each other in the Z direction and are fastened by the bolt BT1. In this case, the bolt BT1 is tightened toward the negative side along the Z direction.

Similarly, the N terminal 62 has a fastening surface 621 (a surface having a hole for fastening a bolt BT2) whose normal direction is the vertical direction (example of first direction). The fastening surface 621 forms a fastening surface with the negative terminal 12 of the power supply connector 10. That is, the N terminal 62 and the negative terminal 12 overlap each other in the Z direction and are fastened by the bolt BT2. In this case, the bolt BT2 is tightened toward the negative side along the Z direction. Note that, in the present embodiment, the fastening surface 611 and the fastening surface 621 are surfaces in the same plane, but in the modification, one may be offset from the other in the vertical direction.

Furthermore, as well illustrated in FIG. 5A, the ground terminal 63 has a fastening surface 631 (a surface having a hole for fastening a bolt BT3) whose normal direction is the Y direction (example of second direction). The fastening surface 631 forms a fastening surface with a member having a ground potential. In the present embodiment, as an example, the member having the ground potential is the water passage forming member 294. The fastening surface on the water passage forming member 294 side is a side surface whose normal direction is the Y direction. Note that the side surface that is the fastening surface of the water passage forming member 294 faces the side wall portion 244 of the inverter case portion 24 to which the power supply connector 10 is attached. In this case, the ground terminal 63 and the water passage forming member 294 overlap each other in the Y direction and are fastened by the bolt BT3. In this case, the bolt BT3 is tightened toward the positive side along the Y direction.

Meanwhile, for example, in a Y capacitor 60' of the comparative example schematically illustrated in FIG. 6, terminals 61', 62', and 63' have fastening surfaces whose normal direction is the vertical direction, which is different from the present embodiment. In this case, when viewed in the vertical direction, the fastening surfaces (in particular, bolt holes) of the terminals 61', 62', and 63' need to be arranged at positions not overlapping each other in consideration of workability during bolt fastening. Therefore, in such a comparative example, the mounting space of the Y capacitor 60' when viewed in the vertical direction tends to be relatively large. That is, the mounting space of the Y capacitor 60' tends to be a factor that hinders downsizing (in the XY plane) of the power conversion device.

On the other hand, according to the present embodiment, as described above, the fastening surfaces 611 and 621 of the P terminal 61 and the N terminal 62 and the fastening surface 631 of the ground terminal 63 have different normal directions. As a result, the mounting space of the Y capacitor 60 can be reduced.

Here, in the present embodiment, the fastening surfaces 611 and 621 of the P terminal 61 and the N terminal 62, respectively, and the ground terminal 63 or the bolt BT3 for fastening the ground terminal 63 may be arranged in an overlapping positional relationship when viewed in the vertical direction. For example, when viewed in the vertical direction, the fastening surface 611 (or the bolt BT1 fastened thereto) may overlap one of the bolts BT3 fastening the ground terminals 63, and the fastening surface 621 (or the bolt BT2 fastened thereto) may overlap the other of the bolts BT3 fastening the ground terminals 63. In this case, the mounting space of the Y capacitor 60 can be more effectively reduced.

In addition, according to the present embodiment, as described above, the mounting space of the Y capacitor 60 can be set adjacent to the side wall portion 244. That is, when viewed in the vertical direction, the mounting space of the Y capacitor 60 can be relatively largely moved toward the negative side in the Y direction in a manner adjacent to the side wall portion 244. As a result, it is easy to secure the mounting space of other components on the positive side in the Y direction of the Y capacitor 60 in the inverter housing chamber S4. In addition, by moving the mounting space of other components toward the negative side in the Y direction, the size of the power conversion device 80 in the Y direction can be reduced. For example, in a case where the Y capacitor 60 is disposed between the smoothing capacitor 84 and the side wall portion 244 in the Y direction as in the present embodiment, the distance in the Y direction between the smoothing capacitor 84 and the side wall portion 244 can be minimized. As a result, it is possible to effectively reduce the size of the power conversion device 80 in the Y direction.

Here, in the present embodiment, the water passage forming member 294 preferably has a recess 2940 that is recessed to a side away from the side wall portion 244 when viewed in the vertical direction as illustrated in FIG. 8. In this case, the ground terminal 63 may be disposed in the recess 2940 as illustrated in FIG. 7. In addition, the entire board 66 and a part of the bolt BT3 may also be arranged in the recess 2940 as illustrated in FIG. 7. As a result, as compared with a case where the recess 2940 is not formed, the mounting space of the Y capacitor 60 can be further moved in the Y direction with respect to the side wall portion 244. As a result, it is possible to effectively reduce the size of the power conversion device 80 in the Y direction.

Note that, in the present embodiment, the Y capacitor 60 can be assembled to the inverter case portion 24 in a state where the P terminal 61, the N terminal 62, the ground terminal 63, and the board 66 are assembled to the water passage forming member 294 together with the capacitors C10 and C20 (that is, in a state where the ground terminal 63 is fastened to the water passage forming member 294 by the bolt BT3). In this case, fastening between the P terminal 61 and the positive terminal 11 of the power supply connector 10 and between the N terminal 62 and the negative terminal 12 of the power supply connector by the bolts BT1 and BT2 may be performed after the water passage forming member 294 (and the Y capacitor 60 accordingly) is assembled to the inverter case portion 24. In this case, by assembling the power supply connector 10 to the side wall portion 244 of the inverter case portion 24, and fastening the P terminal 61 and the positive terminal 11 of the power supply connector 10, which overlap each other in the vertical direction, by the bolt BT1, and the N terminal 62 and the negative terminal 12 of the power supply, which overlap each other in the vertical direction, by the bolt BT2, assembling of the Y capacitor 60 can be easily completed.

Although each embodiment has been described in detail above, it is not limited to a specific embodiment, and various modifications and changes can be made within the scope described in the claims. In addition, all or a plurality of the components of the embodiment described above can be combined.

For example, in the embodiment described above, the cylindrical capacitors C10 and C20 are arranged in a manner that the axial direction is along the Z direction, but it is not limited thereto. For example, the cylindrical capacitors C10 and C20 may be arranged in a manner that the axial direction is along the X direction. In this case, the mounting space in the X direction can be increased, but the mounting space in the Z direction can be reduced, and the size of the power conversion device 80 in the height direction can be reduced.

Furthermore, in the embodiment described above, the P terminal 61 and the N terminal 62 is not configured to be elastically deformable in the vertical direction, but the P terminal 61 and the N terminal 62 may be configured to be elastically deformable in the vertical direction. For example, the P terminal 61 and the N terminal 62 may have elastically deformable elastic deformation portions (not illustrated) that support the fastening surfaces 611 and 621 so as to be displaceable in the vertical direction. In this case, even in a case where a deviation from a design value (nominal value) occurs between the fastening surface 611 of the P terminal 61 and the fastening surface of the positive terminal 11 of the power supply connector 10 due to various tolerances such as an assembly tolerance, the deviation can be absorbed by the elastic deformation of the elastic deformation portion, and the stress of the fastening portion can be reduced. Similarly, even in a case where a deviation from a design value (nominal value) occurs between the fastening surface 621 of the N terminal 62 and the fastening surface of the negative terminal 12 of the power supply connector 10, the deviation can be absorbed by the elastic deformation of the elastic deformation portion, and the stress of the fastening portion can be reduced. Note that any form of the elastic deformation portion is possible, and the elastic deformation portion may be in a form of a leaf spring.

Moreover, in the embodiment described above, the power supply connector 10 is fitted into the side wall portion 244, but instead of the power supply connector 10, a terminal portion with another form may be fitted into the side wall portion 244 or the like.

### REFERENCE SIGNS LIST

1: Rotary electric machine, 2: Case, 244: Side wall portion, 60: Y capacitor, 61: P terminal (First terminal), 62: N terminal (Second terminal), 63: GN terminal (Third terminal), 611, 621: Fastening surface (First fastening surface), 631: Fastening surface (Second fastening surface), 80: Power conversion device, 84: Smoothing capacitor, 294: Water passage forming member (Member having a ground potential), 2940: Recess, 100: Vehicular drive device, and BT3: Bolt (Fastener)

## Claims

1. A vehicular drive device comprising:
a power conversion device that supplies power to a rotary electric machine;
a case that houses the power conversion device;
a Y capacitor that is housed in the case and electrically connected between the power conversion device and a power supply;
a first terminal that electrically connects the Y capacitor to a positive side of the power supply;
a second terminal that electrically connects the Y capacitor to a negative side of the power supply; and
a third terminal that electrically connects the Y capacitor to a ground, wherein
the first terminal and the second terminal have a first fastening surface with a terminal from a power supply side, a normal direction of the first fastening surface being a first direction, and
the third terminal has a second fastening surface with a member having a ground potential, a normal direction of the second fastening surface being a second direction different from the first direction.

2. The vehicular drive device according to claim 1, wherein the first fastening surface of at least one of the first terminal or the second terminal overlaps the third terminal or a fastener that fastens the third terminal when viewed in the first direction.

3. The vehicular drive device according to claim 1, further comprising a smoothing capacitor that is housed in the case and electrically connected between the Y capacitor and the power conversion device, wherein
the case has a side wall portion on which a positive-side terminal and a negative-side terminal from the power supply are arranged, and
the Y capacitor is disposed between the side wall portion and the smoothing capacitor in the second direction.

4. The vehicular drive device according to claim 3, wherein the first direction corresponds to a vertical direction of the side wall portion, and the second direction corresponds to a direction perpendicular to a surface of the side wall portion.

5. The vehicular drive device according to claim 3 or 4, wherein the member having the ground potential has a recess recessed to a side away from the side wall portion in the second direction when viewed in the first direction, and
at least a part of the third terminal or at least a part of a fastener that fastens the third terminal is disposed in the recess when viewed in the first direction.
